# EUROPEAN PATENT SPECIFICATION

(11) **EP 2 528 421 B1**
(45) Date of publication and mention of the grant of the patent: **08.10.2014**
(21) Application number: 11305644.4
(22) Date of filing: 26.05.2011
(51) Int. Cl.: H05K 1/14

(54) **Serial link interconnection arrangement for backplane with embedded waveguide**
Verbindungsanordnung mit seriellem Anschluss für Rückwandplatine mit eingebettetem Wellenleiter
Agencement d'interconnexion pour panneau arrière doté d'un guide d'onde intégré

(43) Date of publication of application: 28.11.2012
(73) Proprietor: ALCATEL LUCENT, 92100 Boulogne-Billancourt (FR)
(72) Inventor: Hooghe, Koen, 2600 Berchem (BE)
(74) Representative: ALU Antw Patent Attorneys

(56) References cited:
- EP-A1- 1 677 382
- EP-A2- 1 804 075

## Description

The present invention relates to a serial link interconnection arrangement for interconnecting a first printed circuit board with a second printed circuit board, both printed circuit boards being inserted in a backplane of a telecommunication system.

Current technology for interconnecting printed circuit boards PCB is using copper traces to connect connectors, with inserted boards, over a backplane. Current state of the art backplane technology is capable of providing 10 Gbps serial transmission between printed circuit boards over the backplane.

Standardization is working on 25 ... 28 Gbps serial transmission over such backplanes. The passive channels, comprising the backplane connectors and the copper tracks on the backplane, have proven to provide channels with a "limited" bandwidth. The current state of the art is less than 25 GHz and shows a quite strong attenuation over longer distances, typically found in backplanes up to 60 ... 100 cm.

However, for a number of applications, e.g. in telecommunication systems, even higher speed serial transmission would be desirable in order to limit the number of pins/transceivers and the associated power consumption.

An object of the present invention is to provide a serial link arrangement of the above known type but which provides a reliable high speed channel between two printed circuit boards PCB inserted in a backplane, e.g. for a serial link speed larger than 25 Gbps.

According to a characterizing embodiment of the invention, this object is achieved due to the fact that said serial link interconnection arrangement comprises a waveguide embedded in said backplane, that a first end of said waveguide is coupled to said first printed circuit board via a first connection system, whilst the second end of said waveguide is coupled to said second printed circuit board via a second connection system, and that each of said connection systems comprises a transceiver adapted to convert a parallel signal received from the printed circuit board into a serial stream transmitted to an end of said waveguide via an antenna, and vice-versa.

In this way, a high speed serial link interconnection arrangement is provided wherein the connection systems, associated to the waveguide embedded in the backplane, allow achieving transmission of information between the printed circuit boards by means of a very high speed serial stream, e.g. at a speed larger than 25 Gbps.

Another characterizing embodiment of the present invention is that each of said printed circuit boards is provided with an external connector adapted to be coupled to a parallel connection bus of said transceiver.

Also another characterizing embodiment of the present invention is that said external connector is provided with a plurality of copper pads, and that said parallel connection bus is provided with a plurality of external pins adapted to be coupled to respective copper pads of said external connector.

In this way, the transmission of signals between the printed circuit board and the transceiver can be performed through a "low speed" parallel interface.

In a preferred characterizing embodiment of the present invention, said plurality of external pins is a Land Grid Array type connector.

The Land Grid Array LGA connector is generally known for connecting a Central Processing Unit CPU to a motherboard. The LGA-type connector is advantageously used in the present invention for solving a number of issues with mechanical alignment and interconnectivity.

Also another characterizing embodiment of the present invention is that said transceiver is powered by the printed circuit board via said external connector.

This is an easy and reliable way for providing power supply to the transceiver.

In a preferred characterizing embodiment of the present invention, said transceiver is mounted in a flexible way on said backplane.

In this way, the interconnection of the transceiver with the external connector is improved.

Further characterizing embodiments of the present high speed serial link interconnection arrangement are mentioned in the appended claims.

It is to be noticed that the terms "comprising" or "including", used in the claims, should not be interpreted as being restricted to the means listed thereafter. Thus, the scope of an expression such as "a device comprising means A and B" should not be limited to an embodiment of a device consisting only of the means A and B. It means that, with respect to embodiments of the present invention, A and B are essential means of the device.

Similarly, it is to be noticed that the term "coupled", also used in the claims, should not be interpreted as being restricted to direct connections only. Thus, the scope of the expression such as "a device A coupled to a device B" should not be limited to embodiments of a device wherein an output of device A is directly connected to an input of device B. It means that there may exist a path between an output of A and an input of B, which path may include other devices or means.

The above and other objects and features of the invention will become more apparent and the invention itself will be best understood by referring to the following description of an embodiment taken in conjunction with the accompanying drawings wherein:
Fig. 1 represents a serial link interconnection arrangement according to the invention for a high speed interconnection between two printed circuit boards inserted in a backplane; and
Fig. 2 shows the connection system ConA of the serial link interconnection arrangement of Fig. 1 in more detail.

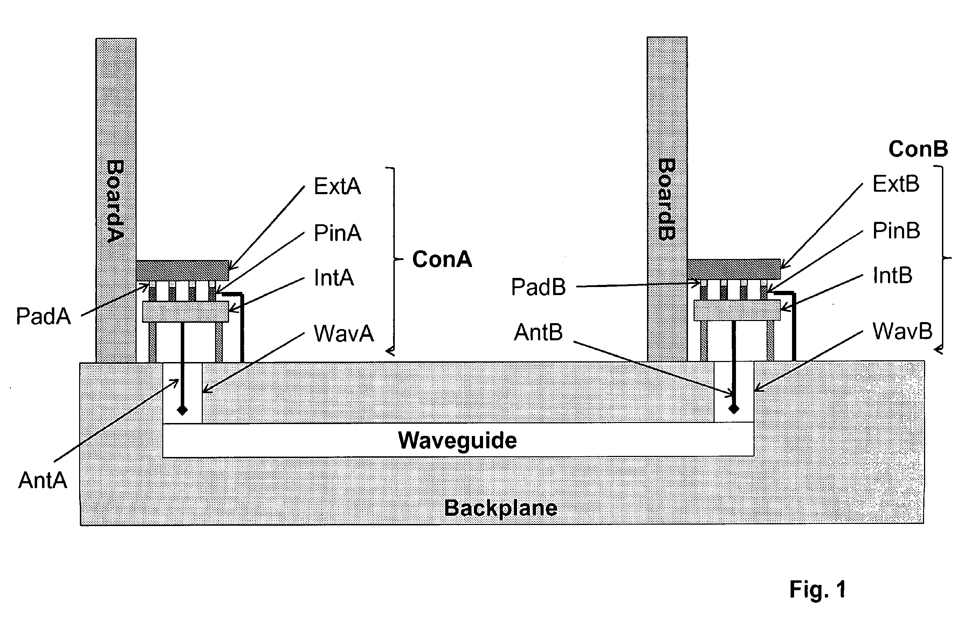

The present serial link interconnection arrangement provides a solution for the transmission of information from a printed circuit board BoardA to another printed circuit board BoardB by using waveguide technology in a backplane, e.g. of a telecommunication system, as represented at Fig. 1.

The printed circuit boards BoardA and BoardB are inserted in the backplane and the waveguide is embedded in this backplane and has ends exiting from the backplane at locations close to the boards.

A first end WavA of the waveguide is coupled to the first board BoardA via a first connection system ConA, whilst the second end WavB of the waveguide is coupled to the second board BoardB via a second connection system ConB, similar to the first connection system ConA.

The connection systems ConA and ConB allow coupling the two boards BoardA and BoardB by a serial stream through the waveguide. To this end, each connection system ConA/ConB comprises a transceiver IntA/IntB adapted to convert a parallel signal received from a printed circuit board BoardA/BoardB into a serial stream transmitted to an end WavA/WavB of the waveguide via an antenna AntA/AntB thereof, and vice-versa. The transceivers or transmit and receive circuits IntA and IntB incorporated in the connection systems of the backplane solves a number of issues with mechanical alignment and interconnectivity.

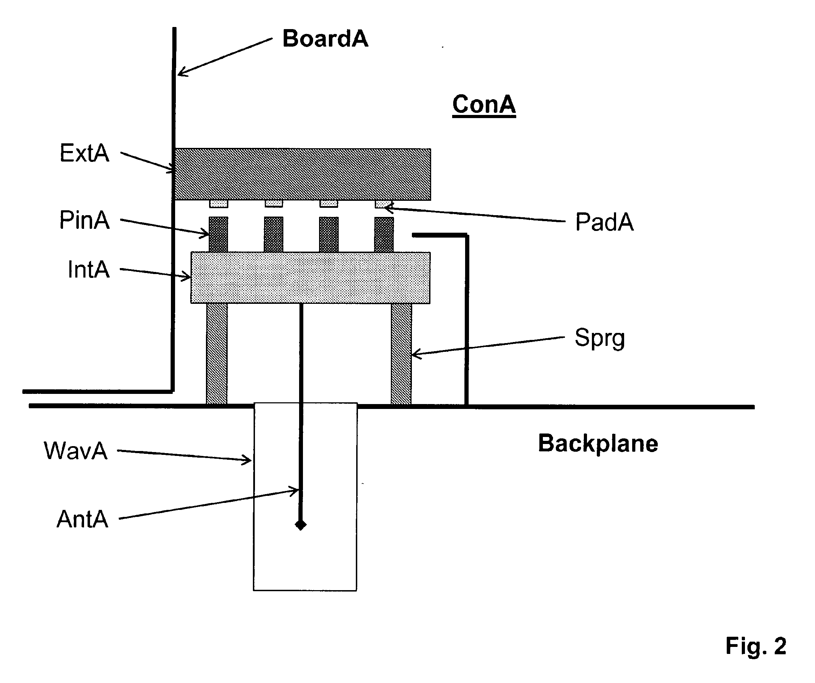

One of the two similar connection systems, e.g. ConA, is shown in more detail at Fig. 2. The connection system ConA comprises two parts for interfacing with the waveguide embedded in the backplane:
- a first part fixed on the BoardA; and
- a second part fixed on the backplane.

The first part of the connection system ConA, which is an external connector ExtA located on the board BoardA inserted in the backplane, provides a "low speed" parallel interface. The connection consists of, e.g., a small printed circuit board with copper pads PadA which will interface with the second part of the connection system.

The second part of the connection system ConA is located at the backplane and consists of an active component, e.g. a transmitter IntA, which takes in the "low speed" parallel interface from the first part of the connection system ConA and transforms the parallel bus into a serial stream which is to be transmitted into the waveguide by the integrated antenna AntA.

The parallel connection bus of the transceiver IntA is coupled to the external connector ExtA via external pins PinA adapted to be connected to respective copper pads PadA of the printed circuit board BoardA. The external pins PinA preferably have the style of a Land Grid Array LGA.

The active component IntA can for instance be powered by the board BoardA inserted into a slot of the backplane through the same type of pins as used for the parallel bus, i.e. via the external connector ExtA.

The active component or transceiver IntA is preferably mounted in a flexible way on the backplane such that proper alignment and proper contact can be made with the first part of the connection system ConA.

This alignment is improved by the land grid array LGA style of connection system between the first part and the second part of the connection system and by a spring type of system Sprg between the active component IntA and the backplane to assure that the contact is made with sufficient force. The spring type of system Sprg further fixes the transceiver IntA to the backplane.

It is to be noted that although only the design and operation of the connection system ConA of the serial link interconnection arrangement has been explained above, the reverse happens at the receiver side, i.e. at the location of the printed circuit board BoardB. In **Fig. 1** the same labels are used for BoardB as for BoardA, only the final letter A is then replaced by B.

A final remark is that embodiments of the present invention are described above in terms of functional blocks. From the functional description of these blocks, given above, it will be apparent for a person skilled in the art of designing electronic devices how embodiments of these blocks can be manufactured with well-known electronic components. A detailed architecture of the contents of the functional blocks hence is not given.

While the principles of the invention have been described above in connection with specific apparatus, it is to be clearly understood that this description is merely made by way of example and not as a limitation on the scope of the invention, as defined in the appended claims.

## Claims

1. A serial link interconnection arrangement for interconnecting a first printed circuit board (BoardA) with a second printed circuit board (BoardB), both printed circuit boards being inserted in a backplane of a telecommunication system,
***characterized in that*** said serial link interconnection arrangement comprises a waveguide embedded in said backplane,
***in that*** a first end (WavA) of said waveguide is coupled to said first printed circuit board (BoardA) via a first connection system (ConA), whilst the second end (WavB) of said waveguide is coupled to said second printed circuit board (BoardB) via a second connection system (ConB),
*and **in that*** each of said connection systems (ConA; ConB) comprises a transceiver (IntA; IntB) adapted to convert a parallel signal received from the printed circuit board (BoardA; BoardB) into a serial stream transmitted to an end (WavA; WavB) of said waveguide via an antenna (AntA; AntB), and vice-versa.

2. The serial link interconnection arrangement according to claim 1, ***characterized in that*** each of said printed circuit boards (BoardA; BoardB) is provided with an external connector (ExtA; ExtB) adapted to be coupled to a parallel connection bus of said transceiver (IntA; IntB).

3. The serial link interconnection arrangement according to claim 2,
***characterized in that*** said external connector (ExtA; ExtB) is provided with a plurality of copper pads (PadA; PadB),
*and **in that*** said parallel connection bus is provided with a plurality of external pins (PinA; PinB) adapted to be coupled to respective copper pads (PadA; PadB) of said external connector (ExtA; ExtB).

4. The serial link interconnection arrangement according to claim 2, ***characterized in that*** said external connector (ExtA; ExtB) is a small printed circuit board.

5. The serial link interconnection arrangement according to claim 3, ***characterized in that*** said plurality of external pins (PinA; PinB) has a Land Grid Array (LGA) style.

6. The serial link interconnection arrangement according to claim 2, ***characterized in that*** said transceiver (IntA; IntB) is powered by the printed circuit board (BoardA; BoardB) via said external connector (ExtA; ExtB).

7. The serial link interconnection arrangement according to claim 1, ***characterized in that*** said antenna (AntA; AntB) is engaged into said waveguide and is adapted to transmit signals from said transceiver (IntA; IntB) to said waveguide, and vice-versa.

8. The serial link interconnection arrangement according to claim 1, ***characterized in that*** said parallel signal of said printed circuit board (BoardA; BoardB) is a relatively low speed signal.

9. The serial link interconnection arrangement according to claim 1, ***characterized in that*** said transceiver (IntA; IntB) is mounted in a flexible way on said backplane.

10. The serial link interconnection arrangement according to claim 9, ***characterized in that*** said transceiver (IntA; IntB) is fixed to said backplane by means of springs (Sprg).

## Patentansprüche

1. Verbindungsanordnung mit seriellem Anschluss, um eine erste Leiterplatte (BoardA) und eine zweite Leiterplatte (BoardB) miteinander zu verbinden, wobei beide Leiterplatten in eine Rückwandplatine eines Telekommunikationssystems eingesteckt werden,
***dadurch gekennzeichnet, dass*** die besagte Verbindungsanordnung mit seriellem Anschluss einen in der besagten Rückwandplatine eingebetteten Wellenleiter umfasst,
*dass* ein erstes Ende (WavA) des besagten Wellenleiters über ein erstes Verbindungssystem (ConA) an die besagte erste Leiterplatte (BoardA) gekoppelt ist, während das zweite Ende (WavB) des besagten Wellenleiters über ein zweites Verbindungssystem (ConB) an die besagte zweite Leiterplatte (BoardB) gekoppelt ist,
*und dass* ein jedes der besagten Verbindungssysteme (ConA; ConB) einen Transceiver (IntA; IntB) umfasst, welcher für das Umwandeln eines von der besagten Leiterplatte (BoardA; BoardB) empfangenen parallelen Signals in einen über eine Antenne (AntA; AntB) an ein Ende (WavA; WavB) des besagten Wellenleiters übertragenen seriellen Strom, und umgekehrt, ausgelegt ist.

2. Verbindungsanordnung mit seriellem Anschluss nach Anspruch 1, ***dadurch gekennzeichnet, dass*** eine jede der besagten Leiterplatten (BoardA; BoardB) mit einem externen Steckverbinder (ExtA; ExtB) versehen ist, welcher für das Ankoppeln an einen parallelen Verbindungsbus des besagten Transceivers (IntA; IntB) ausgelegt ist.

3. Verbindungsanordnung mit seriellem Anschluss nach Anspruch 2,
***dadurch gekennzeichnet, dass*** der besagte externe Steckverbinder (ExtA; ExtB) mit einer Vielzahl von Kupferlötaugen (PadA; PadB) versehen ist,
*und dass* der besagte parallele Verbindungsbus mit einer Vielzahl von externen Kontaktstiften (PinA; PinB), welche für das Ankoppeln an jeweilige Kupferlötaugen (PadA; PadB) des besagten externen Steckverbinders (ExtA; ExtB) vorgesehen sind, versehen ist.

4. Verbindungsanordnung mit seriellem Anschluss nach Anspruch 2, ***dadurch gekennzeichnet, dass*** der besagte externe Steckverbinder (ExtA; ExtB) eine kleine Leiterplatte ist.

5. Verbindungsanordnung mit seriellem Anschluss nach Anspruch 3, ***dadurch gekennzeichnet, dass*** die besagte Vielzahl von externen Kontaktstiften (PinA; PinB) die Form einer Lötaugen-Gitter-Anordnung (LGA) aufweisen.

6. Verbindungsanordnung mit seriellem Anschluss nach Anspruch 2, ***dadurch gekennzeichnet, dass*** der besagte Transceiver (IntA; IntB) über den besagten externen Steckverbinder (ExtA; ExtB) von der Leiterplatte (BoardA; BoardB) gespeist wird.

7. Verbindungsanordnung mit seriellem Anschluss nach Anspruch 1, ***dadurch gekennzeichnet, dass*** die besagte Antenne (AntA; AntB) in den besagten Wellenleiter eingreift und dazu ausgelegt ist, Signale von dem besagten Transceiver (IntA; IntB) an den besagten Wellenleiter, und umgekehrt, zu übertragen.

8. Verbindungsanordnung mit seriellem Anschluss nach Anspruch 1, ***dadurch gekennzeichnet, dass*** das besagte parallele Signal der besagten Leiterplatte (BoardA; BoardB) ein Signal mit relativ niedriger Geschwindigkeit ist.

9. Verbindungsanordnung mit seriellem Anschluss nach Anspruch 1, ***dadurch gekennzeichnet, dass*** der besagte Transceiver (IntA; IntB) in flexibler Weise auf der besagten Rückwandplatine montiert ist.

10. Verbindungsanordnung mit seriellem Anschluss nach Anspruch 9, ***dadurch gekennzeichnet, dass*** der besagte Transceiver (IntA; IntB) anhand von Federn (Sprg) an der besagten Rückwandplatine befestigt ist.

## Revendications

1. Dispositif d'interconnexion de liaison série pour interconnecter une première carte de circuit imprimé (BoardA) avec une deuxième carte de circuit imprimé (BoardB), les deux cartes de circuit imprimé étant insérées dans un fond de panier d'un système de télécommunication,
***caractérisé en ce que*** ledit dispositif d'interconnexion de liaison série comprend un guide d'ondes intégré audit fond de panier,
***en ce qu'**une* première extrémité (WavA) dudit guide d'ondes est couplée à ladite première carte de circuit imprimé (BoardA) par l'intermédiaire d'un premier système de connexion (ConA), tandis que la deuxième extrémité (WavB) dudit guide d'ondes est couplée à ladite deuxième carte de circuit imprimé (BoardB) par l'intermédiaire d'un deuxième système de connexion (ConB),
*et **en ce que*** chacun desdits systèmes de connexion (ConA ; ConB) comprend un émetteur/récepteur (IntA ; IntB) adapté pour convertir un signal parallèle provenant de la carte de circuit imprimé (BoardA ; BoardB) en un flux série transmis à une extrémité (WavA ; WavB) dudit guide d'ondes par l'intermédiaire d'une antenne (AntA ; AntB), et inversement.

2. Dispositif d'interconnexion de liaison série selon la revendication 1, ***caractérisé en ce que*** chacune desdites cartes de circuit imprimé (BoardA ; BoardB) est dotée d'un connecteur externe (ExtA ; ExtB) adapté pour être couplé à un bus de connexion parallèle dudit émetteur/récepteur (IntA ; IntB).

3. Dispositif d'interconnexion de liaison série selon la revendication 2,
***caractérisé en ce que*** ledit connecteur externe (ExtA ; ExtB) est doté d'une pluralité de pastilles en cuivre (PadA ; PadB),
*et **en ce que*** ledit bus de connexion parallèle est doté d'une pluralité de broches externes (PinA ; PinB) adaptées pour être couplées à des pastilles en cuivre respectives (PadA ; PadB) dudit connecteur externe (ExtA ; ExtB).

4. Dispositif d'interconnexion de liaison série selon la revendication 2, ***caractérisé en ce que*** ledit connecteur externe (ExtA ; ExtB) est une petite carte de circuit imprimé.

5. Dispositif d'interconnexion de liaison série selon la revendication 3, ***caractérisé en ce que*** ladite pluralité de broches externes (PinA ; PinB) présente un style de grille matricielle à billes (LGA).

6. Dispositif d'interconnexion de liaison série selon la revendication 2, ***caractérisé en ce que*** ledit émetteur/récepteur (IntA ; IntB) est alimenté en puissance par la carte de circuit imprimé (BoardA ; BoardB) par l'intermédiaire dudit connecteur externe (ExtA ; ExtB).

7. Dispositif d'interconnexion de liaison série selon la revendication 1, ***caractérisé en ce que*** ladite antenne (AntA ; AntB) est engagée dans ledit guide d'ondes et est adaptée pour transmettre des signaux entre ledit émetteur/récepteur (IntA ; IntB) et ledit guide d'ondes, et inversement.

8. Dispositif d'interconnexion de liaison série selon la revendication 1, ***caractérisé en ce que*** ledit signal parallèle de ladite carte de circuit imprimé (BoardA ; BoardB) est un signal à vitesse relativement faible.

9. Dispositif d'interconnexion de liaison série selon la revendication 1, ***caractérisé en ce que*** ledit émetteur/récepteur (IntA ; IntB) est monté de manière flexible sur ledit fond de panier.

10. Dispositif d'interconnexion de liaison série selon la revendication 9, ***caractérisé en ce que*** ledit émetteur/récepteur (IntA ; IntB) est fixé audit fond de panier au moyen de ressorts (Sprg).
